Europäisches Patentamt

European Patent Office

Office européen des brevets

(19)

(11) Numéro de publication : **0 013 224**
**B1**

(12) **FASCICULE DE BREVET EUROPÉEN**

(45) Date de publication du fascicule du brevet :
03.11.82

(21) Numéro de dépôt : **79401036.3**

(22) Date de dépôt : **19.12.79**

(51) Int. Cl.³ : **G 01 V 3/20**

(54) **Procédé et dispositif pour mesurer la résistivité des fluides dans un sondage.**

(30) Priorité : **27.12.78 FR 7836415**

(43) Date de publication de la demande :
**09.07.80 (Bulletin 80/14)**

(45) Mention de la délivrance du brevet :
**03.11.82 Bulletin 82/44**

(84) Etats contractants désignés :
**AT DE FR GB IT NL**

(56) Documents cités :
**DE B 1 056 749**
**US A 3 115 602**
**US A 3 134 941**

(73) Titulaire : **SOCIETE DE PROSPECTION ELECTRIQUE SCHLUMBERGER**
**42, rue Saint-Dominique**
**F-75340 Paris Cedex 07 (FR)**
**DE FR IT NL AT**
**Schlumberger Limited**
**277 Park Avenue**
**New York, N.Y. 10017 (US)**
**GB**

(72) Inventeur : **Moulin, Pierre A.**
**49, avenue de la Résistance**
**F-92370 Chaville (FR)**

(74) Mandataire : **Chareyron, Lucien et al**
**Schlumberger Limited Service Brevets 42, rue Saint-Dominique**
**F-75340 Paris Cedex 07 (FR)**

Imprimerie Jouve, 18, rue St-Denis, 75001 Paris, France

## Procédé et dispositif pour mesurer la résistivité des fluides dans un sondage

La présente invention concerne les procédés et appareils de diagraphie utilisés dans les sondages et notamment un procédé et un dispositif pour mesurer la résistivité ou la conductivité des fluides dans un sondage.

Il a déjà été proposé des appareils de diagraphie qui sont descendus dans les sondages pour mesurer la résistivité électrique des fluides du sondage constitués le plus souvent par de la boue de forage. Il est très intéressant de connaître la résistivité de la boue à chaque profondeur du sondage car cette résistivité entre en jeu lorsqu'on corrige l'influence du trou de sondage sur les diverses mesures. De plus, comme la boue s'infiltre dans les formations perméables en chassant l'eau de formation et une partie des hydrocarbures éventuels dans la « zone envahie », la connaissance de la résistivité des fluides du sondage est essentielle pour la détermination de la résistivité vraie des formations. On connaît plusieurs appareils pour mesurer la résistivité (ou la conductivité) des fluides d'un sondage.

Dans certains appareils comme celui décrit dans le brevet des Etats Unis d'Amérique No 2 922 103 (O. R. Smith) on fait passer les fluides du forage à l'intérieur d'un corps de façon à effectuer la mesure de résistivité sur un volume de fluides de forme déterminée entouré d'un isolant. De préférence le volume de fluides est un cylindre de section constante. La mesure de résistivité est alors similaire à celle effectuée en surface sur un échantillon de boue. Un inconvénient de ces appareils est que, pour les fluides de viscosité élevée, le passage au travers de l'appareil peut se boucher. On n'est jamais sûr que du cake de boue ou des débris n'obstruent pas le passage tout en donnant quand même une lecture plausible.

Dans un autre appareil, décrit dans le brevet des Etats Unis d'Amérique No 3 115 602 (E. W. Sutton et al) on mesure la résistivité des fluides du sondage qui se trouvent à l'intérieur d'un organe en forme de U fixé à la partie inférieure d'une sonde. Ici encore, les fluides du sondage doivent s'écouler par un passage de la sonde dont on est jamais sûr qu'il ne contient pas de débris perturbateurs susceptibles de fausser la mesure.

Un autre type d'appareil est décrit dans le brevet des Etats Unis d'Amérique No 2 838 730 (M. P. Lebourg). Sur un mandrin sont disposées de petites électrodes ponctuelles qui forment un appareil du type « microrésistivité » à faible profondeur d'investigation. Malheureusement dès que les électrodes se rapprochent de la paroi du sondage le système devient sensible à la résistivité des formations et l'on ne lit plus la résistivité vraie des fluides du sondage. Ce dispositif est sensible à l'excentration de la sonde par rapport à l'axe du sondage.

Le brevet des Etats Unis d'Amérique No 3 134 941 (R. G. Norelius) décrit une sonde qui peut, dans certaines circonstances, mesurer la résistivité des fluides du sondage. En emettant autour du corps de sonde un courant électrique dans les fluides du sondage, et en détectant une différence de potentiel entre des électrodes annulaires placées sur la surface latérale du corps, on peut déduire la résistivité des fluides du sondage dans certains cas favorables où le diamètre du sondage est suffisamment élevé. Cet appareil est sensible à la résistivité des formations dès que les électrodes se rapprochent de la paroi par exemple en cas de réduction du diamètre du sondage, ou si le puits est fortement dévié.

L'objet de l'invention se rapporte à une technique de mesure de la résistivité des fluides dans un sondage qui est insensible à l'excentration et à l'orientation de la sonde dans un puits.

L'objet de l'invention se rapporte en outre à une technique utilisable dans des fluides de viscosité importante tels que des boues épaisses.

Selon l'invention, un procédé pour mesurer la résistivité des fluides dans un sondage au moyen d'un corps de sonde susceptible d'être déplacé dans le sondage et portant sur sa surface latérale une première paire d'électrodes annulaires disposées de part et d'autre d'une deuxième paire d'électrodes annulaires comprend les étapes consistant à émettre autour du corps de sonde un courant électrique dans les fluides du sondage entre les électrodes d'une desdites paires et à détecter une différence de potentiel dans les fluides du sondage entre les électrodes de l'autre paire. Le procédé est caractérisé en ce que l'on maintient les électrodes à une distance latérale de la paroi du sondage au moins égale à l'espacement longitudinal entre les électrodes de la première paire afin de déduire un signal représentatif de la résistivité des fluides du sondage quelle que soit la position du corps dans le sondage.

Selon l'invention, un dispositif pour mesurer la résistivité des fluides dans un sondage comprend : un corps susceptible d'être déplacé dans le sondage, et portant sur sa surface latérale une première paire d'électrodes annulaires situées de part et d'autre d'une deuxième paire d'électrodes annulaires, des moyens d'émission pour émettre du courant électrique dans les fluides du sondage tout autour du corps entre les électrodes d'une desdites paires, et des moyens de détection pour détecter une différence de potentiel dans les fluides du sondage entre les électrodes de l'autre paire. Le dispositif est caractérisé en ce qu'il comprend en outre, des moyens sur le corps pour maintenir les électrodes à une distance latérale de la paroi du sondage au moins égale à l'espacement longitudinal entre les électrodes de la première paire afin d'obtenir un signal représentatif de la résistivité des fluides du sondage quelle que soit la position du corps dans le sondage.

Pour maintenir les électrodes éloignées de la paroi du sondage on réalise une partie du corps de diamètre réduit comprise entre deux parties du corps de diamètre plus élevé, les électrodes annulaires étant disposées sur cette partie du corps de diamètre réduit. Des surfaces inclinées coniques relient la partie du corps de diamètre réduit aux parties de diamètre plus élevé, de préférence avec des surfaces de raccordement arrondies pour faciliter l'écoulement des fluides du sondage le long du corps.

Une troisième paire d'électrodes disposées de part et d'autre de la première paire d'électrodes et reliées entre elles diminue la profondeur d'investigation latérale. Le dispositif comprend en outre un capteur de température monté sur le corps.

De préférence les moyens d'émission comprennent des moyens d'alimentation pour émettre dans les fluides du sondage un courant alternatif d'intensité constante et le signal représentatif de la résistivité est obtenu à partir du rapport de la différence de potentiel et de l'intensité du courant.

D'autres caractéristiques et avantages de formes d'exécution de l'invention ressortiront mieux de la description qui va suivre, donnée à titre d'exemple non limitatif, en référence aux figures 1 à 6 des dessins annexés dans lesquels :

la figure 1   est un schéma général d'un appareil de diagraphie dans un sondage ;

la figure 2   représente schématiquement une vue extérieure du dispositif de mesure de résistivité électrique des fluides du sondage ;

la figure 3   représente schématiquement un détail de ce dispositif, vu en coupe longitudinale partielle, au niveau des électrodes ;

la figure 4   illustre le principe de fonctionnement du dispositif à quatre électrodes de la figure 3 ;

la figure 5   représente une variante utilisant six électrodes ; et

la figure 6   représente un schéma synoptique des circuits d'alimentation et de mesure associés aux électrodes des figures 3 et 4.

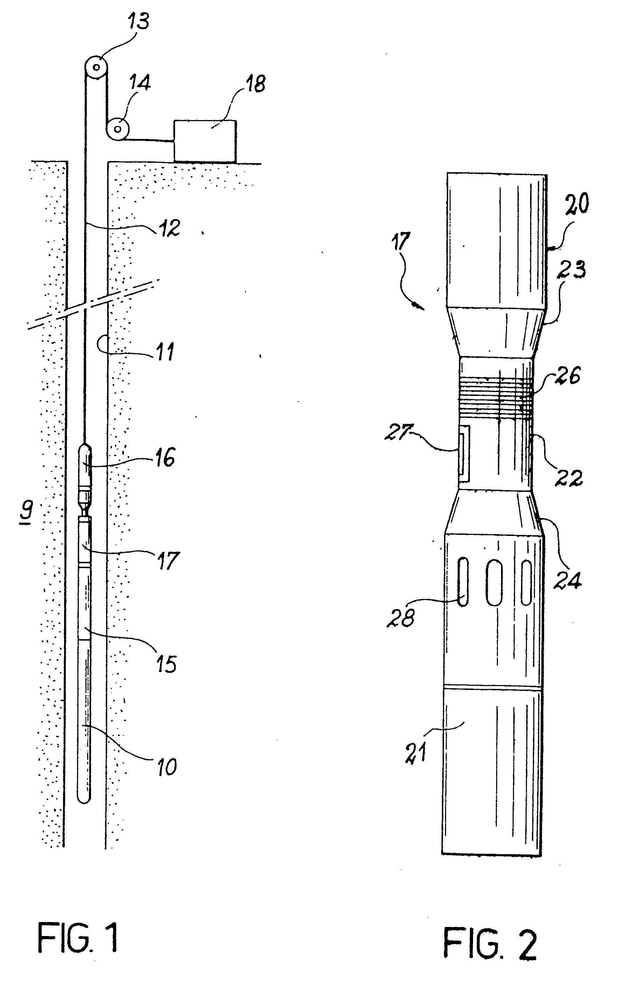

On a représenté sur la figure 1 un appareil de diagraphie 10 mobile dans un sondage 11 foré à travers des formations terrestres 9. Cet appareil est suspendu à l'extrémité d'un câble électrique 12 qui passe sur des poulies 13 et 14 et s'enroule sur un treuil de surface non représenté, qui permet de déplacer l'appareil le long du sondage. Le câble 12 terminé par une tête 16 comporte différents conducteurs qui permettent de transmettre les informations de commande et les informations de mesure entre un équipement de surface 18 et une section de transmission 15 à laquelle sont connectés différents instruments de mesure que renferme l'appareil de diagraphie 10. Entre la tête de câble 16 et la section de transmission 15 est connecté un dispositif 17 de mesure de résistivité selon l'invention, lequel sert à déterminer la résistivité des fluides du sondage en fonction de la profondeur de l'appareil. Le dispositif 17 est traversé par des conducteurs qui prolongent les conducteurs du câble 12 et est relié électriquement par le bas à la section de transmission 15 comme on l'expliquera par la suite. L'appareil de diagraphie 10 est constitué par n'importe quel dispositif de fond classique pour obtenir des mesures de diagraphie des formations, comme des mesures de résistivité des formations, des mesures nucléaires, acoustiques ou autres.

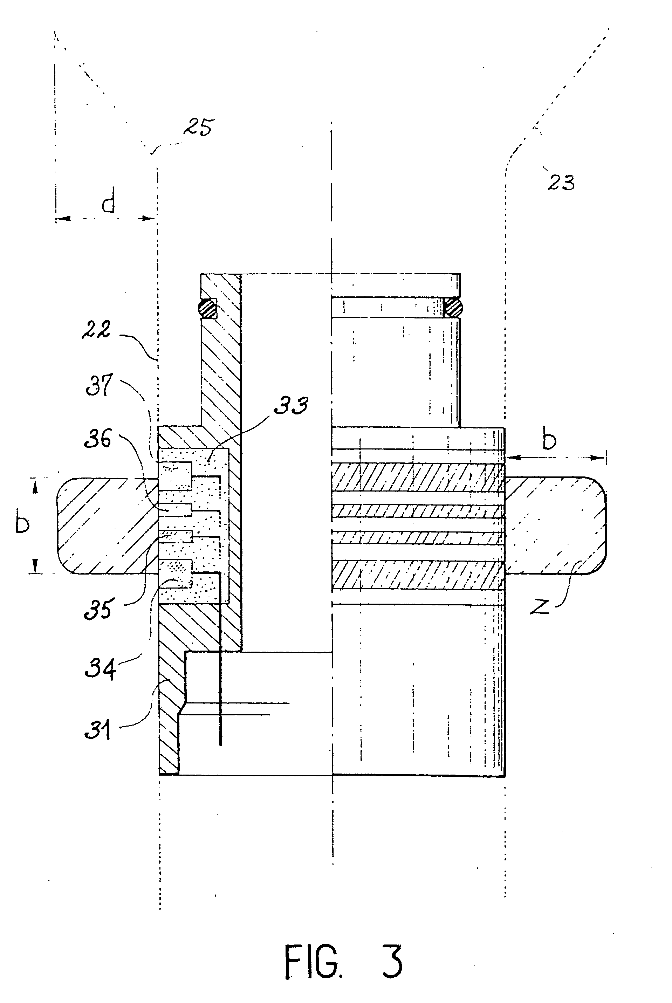

Comme le montrent les figures 2 et 3, le dispositif de mesure de résistivité 17 comprend un corps 20 de forme générale cylindrique dont la surface externe est en contact avec les fluides du sondage. Ce corps 20 cylindrique, a une partie centrale 22 de diamètre réduit comprise entre deux parties extrêmes de diamètre plus élevé auxquelles elle est reliée par des surfaces coniques 23 et 24. Comme on peut le voir sur la figure 3 les surfaces coniques telles que 23 sont reliées aux surfaces cylindriques telles que 22 par des surfaces de raccordement arrondies telles que 25 qui facilitent l'écoulement des fluides du forage le long du corps. On cherche en effet à minimiser les variations rapides de diamètre du corps ainsi que les zones à faibles rayons de courbure qui sont néfastes pour l'écoulement. La partie centrale est en retrait par rapport aux parties extrêmes d'une distance $d$ qui en pratique est égale à environ 1,2 cm. Sur la figure 2, on a schématiquement représenté en 26 les électrodes du dispositif de mesure de résistivité, qui sont des électrodes circulaires disposées annulairement à une faible distance les unes des autres sur le corps, dans sa partie centrale 22, c'est-à-dire en retrait par rapport au reste du corps.

On a également représenté sur la figure 2, à proximité des électrodes 26, un capteur de température 27. Celui-ci est monté pour être exposé vers l'extérieur du corps, comme le sont les électrodes 26. Ce capteur de température est constitué par une plaque métallique en contact avec les fluides du sondage et isolée thermiquement du corps 20. Une résistance variable en fonction de la température sert à mesurer la température de cette plaque, c'est-à-dire des fluides du forage. Les informations de température et de résistivité de la boue peuvent être combinées pour corriger la mesure de résistivité et fournir une indication sur les pertes de fluides ou au contraire les entrées de fluides dans le sondage. La partie inférieure du corps comprend une enveloppe étanche 21 dans laquelle est logée une cartouche qui comporte les différents circuits et dispositifs électroniques associés aux électrodes 26. A chacune de ses extrémités, le corps comporte des filetages non représentés qui permettent de le raccorder d'une part à la tête de câble 16 et d'autre part à la section de transmission 15. Des raccordements sont assurés au niveau des équipements internes, au moyen notamment de connecteurs embrochables qui assurent la continuité des circuits électriques jusqu'aux conducteurs du câble.

La figure 3 illustre d'une manière plus détaillée le mode de montage mécanique des électrodes sur le corps, et plus précisément sur une partie démontable 31 de celui-ci. Quatre électrodes 34, 35, 36 et 37 constituées d'anneaux de métal conducteur sont noyées sur trois faces dans une masse de matériau isolant 33, la quatrième face se trouvant exposée à l'extérieur, au ras du corps. Les quatre électrodes sont disposées à une faible distance les unes des autres. Pour que la profondeur d'investigation latérale soit faible, il faut que l'espacement b entre les deux électrodes extrêmes 34 et 37 soit faible, de préférence inférieur à 2 cm. Ici l'espacement b est approximativement égal à 1,2 cm, c'est-à-dire à la distance d.

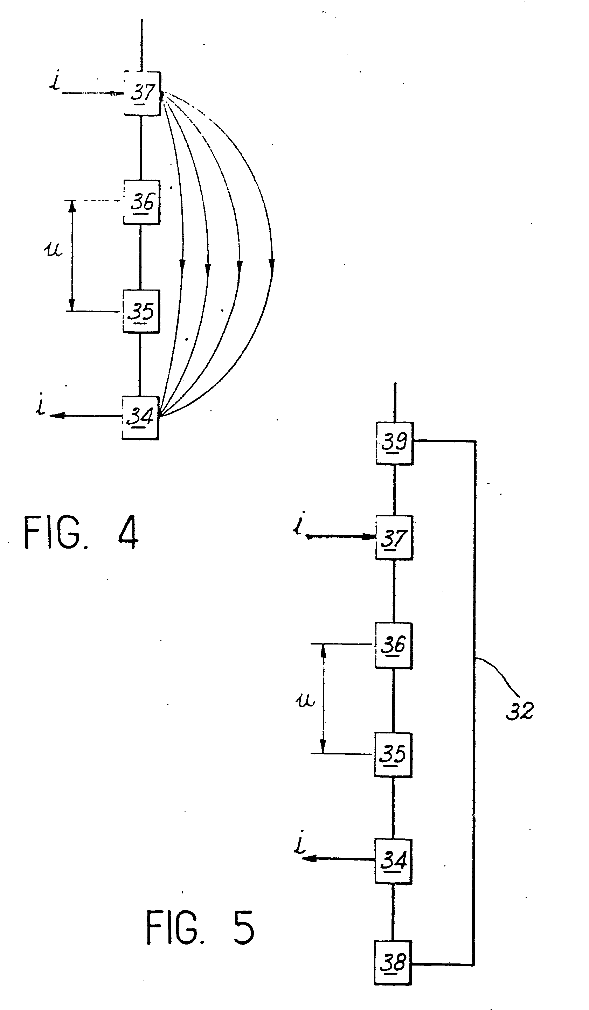

Les quatre électrodes sont montées à potentiel flottant. Les électrodes extrêmes 34 et 37 servent, comme l'illustre la figure 4, à émettre un courant alternatif d'intensité I sensiblement constante, située tout autour du corps. Les lignes de courant ont été schématiquement représentées sur la figure 4. Au moyen des électrodes intermédiaires 35 et 36 on mesure la différence de potentiel alternative qui résulte du champ électrique ainsi créé dans la boue de forage, entre les deux électrodes 34 et 37. Pour calculer la résistivité de la boue on redresse la différence de potentiel alternative u pour obtenir un signal U, on redresse un signal représentatif du courant alternatif i pour obtenir un signal représentatif de l'intensité I, et on fait le rapport U/I pour obtenir un signal représentatif de la résistivité Rm des fluides du sondage. Il est nécessaire de calculer ce rapport car le circuit n'est pas adapté à fournir dans les fluides du sondage un courant i d'intensité I parfaitement constante.

En variante de la figure 4, le dispositif peut comporter deux électrodes complémentaires qui ont été représentées en 38 et 39 sur la figure 5. Il s'agit également d'électrodes circulaires, disposées annulairement autour de l'enveloppe du dispositif, de part et d'autre des quatre électrodes 34 à 37 à l'extérieur de l'ensemble. Les deux électrodes 38 et 39 sont reliées entre elles par un conducteur 32. Elles constituent des électrodes de garde qui limitent l'étendue du champ électrique en direction verticale et la profondeur d'investigation latérale.

En fonctionnement, la forme annulaire des électrodes permet de faire porter les mesures sur une zone annulaire Z (figure 3) qui entoure le dispositif. La profondeur d'investigation latérale du dispositif de mesure à quatre électrodes qui vient d'être décrit est approximativement égale à l'espacement b entre les électrodes extrêmes 34 et 37 d'envoi de courant. En d'autres termes, la zone du sondage qui fournit 95 % de la mesure est comprise dans un cylindre dont le rayon est égal au rayon de la partie centrale du corps plus l'espacement b entre les électrodes extrêmes 34 et 37. En choisissant de placer ces électrodes sur une partie en retrait du corps de façon à maintenir ces électrodes à une distance de la paroi au moins sensiblement égale à l'espacement entre les électrodes extrêmes on rend le dispositif de mesure pratiquement insensible à la résistivité de la paroi du sondage. Même lorsque l'appareil se rapproche de la paroi du sondage, il reste toujours une majeure partie de cette zone annulaire Z dans les fluides du sondage de sorte que la mesure n'est pas sensiblement influencée par les formations bordant le puits. De plus, une rotation de l'appareil sur lui-même n'a aucune conséquence sur les mesures. Par ailleurs, la forme conique du corps de part et d'autre des électrodes est conçue pour ne pas entraver la circulation de la boue sur les électrodes. On évite ainsi le risque de voir se former des dépôts qui pourraient influer sur la résistivité mesurée.

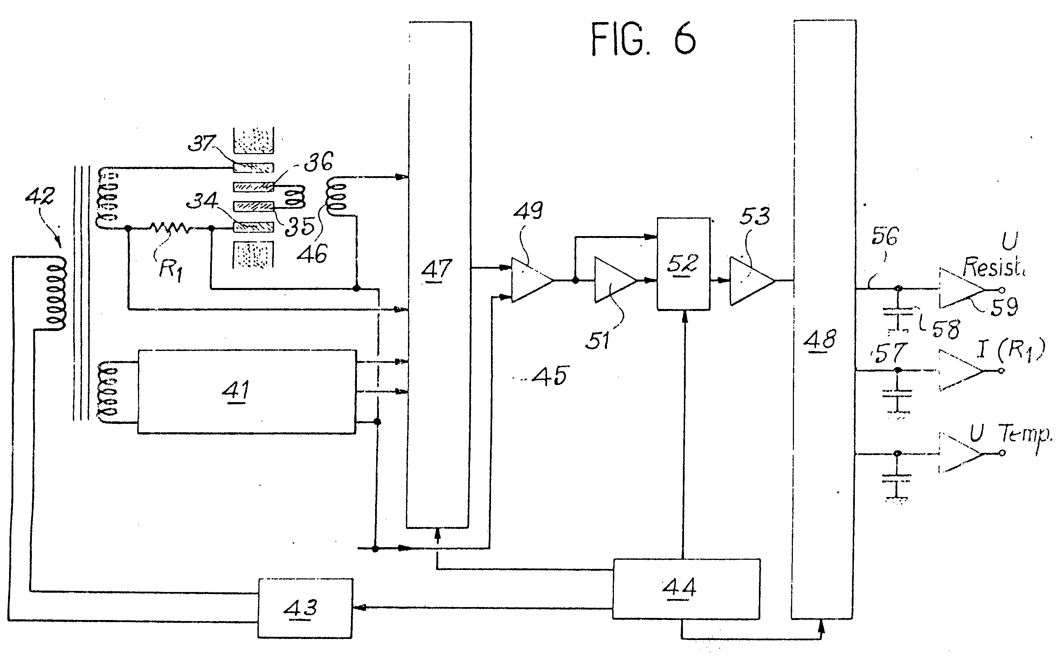

En référence à la figure 6, les circuits du dispositif comprennent un générateur de signaux rectangulaires 44 ayant deux sorties à des fréquences différentes. Une première sortie à haute fréquence (par exemple 1 000 Hz) est connectée à un amplificateur de puissance 43 tandis qu'une sortie basse fréquence (par exemple 100 Hz) commande des commutateurs 47 et 48. Le courant de sortie de l'amplificateur 43 est appliqué par l'intermédiaire d'un transformateur 42 aux électrodes extrêmes 34 et 37. La bobine secondaire du transformateur 42 est branchée en série avec une résistance R1 de faible valeur utilisée pour la mesure du courant émis dans les fluides du sondage. Le courant émis dans les fluides du sondage est donc un courant alternatif à 1 000 Hz ayant une forme d'onde sensiblement carrée et dont l'intensité I est approximativement constante. Les bornes de la résistance R1 sont reliées l'une à une entrée 45 d'un amplificateur différentiel 49, l'autre à une entrée du commutateur 47.

La mesure de différence de potentiel entre les électrodes 35 et 36 est effectuée au moyen d'un transformateur 46 dont le primaire est connecté à ces électrodes et le secondaire à une borne reliée à un commutateur 47 et l'autre borne à l'entrée 45 de l'amplificateur 49. L'amplificateur 49 est relié à un inverseur 51 puis à un détecteur synchrone 52 dont la référence provient du générateur 44. La sortie du détecteur 52 est reliée à un filtre passe-bas 53 connecté au commutateur 48 qui, sous la commande du générateur 44, dirige les signaux redressés U vers une première voie 56 ou les signaux redressés I vers une deuxième voie 57. Chacune de ces deux voies est identique et comprend un condensateur mémoire 58 et un amplificateur de puissance 59 permettant la transmission vers la surface des deux signaux U et I. La transmission en surface s'effectue par l'intermédiaire de la section de transmission 15 qui code ces signaux et les transmet par modulation. Dans l'équipement de surface les signaux U et I sont démodulés, décodés et on effectue le rapport U/I pour obtenir un signal Rm représentatif de la résistivité des fluides du sondage.

L'appareil comprend aussi un circuit similaire 41 pour mesurer la résistance sensible à la température des fluides du sondage et envoyer en surface un signal représentatif de cette température.

Naturellement, ces circuits de mesure, de même que les dispositions qui ont été précisées dans le cours de la description qui précède, sont susceptibles de faire l'objet de nombreuses variantes qui rentrent toutes dans le cadre de la présente invention.

**Revendications**

1. Procédé pour mesurer la résistivité des fluides dans un sondage au moyen d'un corps de sonde (20) susceptible d'être déplacé dans le sondage et portant sur sa surface latérale une première paire d'électrodes annulaires (34, 37) disposées de part et d'autre d'une deuxième paire d'électrodes annulaires (35, 36), procédé dans lequel on émet autour du corps de sonde un courant électrique (i) dans les fluides du sondage entre les électrodes d'une desdites paires, et l'on détecte une différence de potentiel (u) dans les fluides du sondage entre les électrodes de l'autre paire, caractérisé en ce que l'on maintient lesdites électrodes (34, 35, 36, 37) à une distance latérale (d) de la paroi du sondage au moins égale à l'espacement longitudinal (b) entre les électrodes (34, 37) de la première paire afin de déduire un signal représentatif de la résistivité des fluides du sondage quelle que soit la position du corps dans le sondage.

2. Procédé selon la revendication 1, caractérisé en ce que l'on réunit sensiblement au même potentiel électrique une troisième paire d'électrodes annulaires (38, 39) disposées sur la surface latérale du corps de part et d'autre de la première paire d'électrodes (34, 37) pour diminuer la profondeur d'investigation latérale de la mesure.

3. Procédé selon la revendication 1, caractérisé en ce qu'il comprend l'étape de minimiser les variations rapides de diamètre du corps (20) pour faciliter l'écoulement des fluides du sondage, le long du corps.

4. Procédé selon l'une des revendications 1 à 3, caractérisé en ce qu'il comprend de plus les étapes suivantes : détecter la température des fluides du sondage au moyen d'un capteur (27) disposé sur la surface latérale du corps (20) pour élaborer un signal représentatif de cette température, et combiner les signaux représentatifs de la température et de la résistivité pour élaborer un signal corrigé de la résistivité des fluides du sondage.

5. Dispositif pour la mise en œuvre du procédé selon la revendication 1 comprenant :
— un corps susceptible d'être déplacé dans le sondage, ledit corps portant sur sa surface latérale d'une première paire d'électrodes annulaires (24, 37) situées de part et d'autre d'une deuxième paire d'électrodes annulaires (35, 36) ;
— des moyens d'émission (42, 43, 44) pour émettre du courant électrique (i) tout autour du corps dans les fluides du sondage entre les électrodes d'une desdites paire ; et
— des moyens de détection (46, 49, 51, 52, 53) pour détecter une différence de potentiel (u) dans les fluides du sondage entre les électrodes de l'autre paire ; caractérisé en ce qu'il comprend des moyens (22, 23, 24) sur le corps pour maintenir lesdites électrodes à une distance latérale (d) de la paroi du sondage au moins égale à l'espacement longitudinal (b) entre les électrodes (34, 37) de la première paire afin d'obtenir, grâce aux moyens d'émission et de détection, un signal représentatif de la résistivité des fluides du sondage quelle que soit la position du corps dans le sondage.

6. Dispositif selon la revendication 5, caractérisé en ce que les moyens pour maintenir les électrodes à une distance latérale de la paroi du sondage comprennent une partie du corps (22) de diamètre réduit comprise entre deux parties du corps de diamètre plus élevé, les électrodes annulaires (34, 35, 36, 37) étant disposées sur ladite partie du corps (22) de diamètre réduit.

7. Dispositif selon la revendication 6, caractérisé en ce qu'il comprend des surfaces inclinées coniques (23, 24) pour raccorder la partie du corps de diamètre réduit (22) aux parties de diamètre plus élevé pour faciliter l'écoulement des fluides du sondage le long du corps.

8. Dispositif selon la revendication 7, caractérisé en ce que les surfaces inclinées coniques (23, 24), sont raccordées à la partie du corps de diamètre réduit et aux parties du corps de diamètre plus élevé par des surfaces arrondies (25).

9. Dispositif selon l'une des revendications 5 à 8, caractérisé en ce qu'il comprend une troisième paire d'électrodes (38, 39) disposées sur la surface latérale du corps de part et d'autre des premières électrodes (34, 37) et reliées entre elles pour diminuer la profondeur d'investigation latérale de la mesure.

10. Dispositif selon l'une des revendications 5 à 9, caractérisé en ce que l'espacement longitudinal entre les premières électrodes (34, 37) est inférieur à 2 cm.

11. Dispositif selon l'une des revendications 5 à 10, caractérisé en ce que les moyens d'émission comprennent des moyens d'alimentation (44, 43) pour émettre dans les fluides du sondage un courant alternatif d'intensité sensiblement constante.

12. Dispositif selon l'une des revendications 5 à 11, caractérisé en ce qu'il comprend en outre des moyens (R1) pour détecter l'intensité du courant émis dans les fluides du forage et des moyens sensibles au rapport de la différence de potentiel et de l'intensité du courant pour élaborer un signal représentatif de la résistivité des fluides du sondage.

13. Dispositif selon l'une des revendications 5 à 12, caractérisé en ce qu'il comprend de plus, monté sur ledit corps (20) un capteur (27) sensible à la température des fluides du sondage et des moyens (41, 42) reliés au capteur pour élaborer un signal représentatif de cette température.

**Claims**

1. Method for measuring the resistivity of fluids in a borehole by means of a sonde body adapted to be moved in the borehole and having a first pair of annular electrodes (34, 37) which are supported on its lateral surface on each side of a second pair of annular electrodes (35, 36), comprising the steps of passing an electrical current (i) around said sonde body through the fluids in the borehole between the electrodes of one of said pairs, and detecting a potential difference (u) through the fluids of the borehole between the electrodes of the other one of said pairs, characterized by maintaining said electrodes (34, 35, 36, 37) at a lateral distance (d) from the borehole wall which is at least equal to the longitudinal spacing (b) between the electrodes (34, 37) of said first pair to derive a signal representative of the resistivity of the borehole fluids whatever is the position of the body in the borehole.

2. The method according to claim 1, characterized by connecting a third pair of annular electrodes (38, 39) disposed on said lateral surface of the body on each side of said first pair of electrodes (34, 37) at substantially the same electric potential to reduce the lateral depth of investigation of the measurement.

3. The method according to claim 1, characterized by comprising the step of minimizing the fast variations of the diameter of the body (20) to improve the flow of the borehole fluids along the body.

4. The method according to any one of claims 1 to 3, characterized by further comprising the steps of : detecting the temperature of the borehole fluids by means of a sensor (27) disposed on the lateral surface of the body (20) for generating a signal indicative of this temperature ; and combining said signals representative of the resistivity and of the temperature for generating a corrected signal representative of the resistivity of the borehole fluids.

5. Apparatus for implementing the method according to claim 1, comprising :
— a body adapted to be moved in the borehole, said body having a first pair of annular electrodes (34, 37) supported on its lateral surface and located on each side of a second pair of annular electrodes (35, 36) ;
— transmitting means (42, 43, 44) for passing an electrical current (i) around the body through the borehole fluids between the electrodes of one of said pairs ; and
— detecting means (46, 49, 51, 52, 53) for detecting a potential difference (u) through the fluids of the borehole between the electrodes of the other one of said pairs, characterized by comprising means (22, 23, 24) on the body for maintaining said electrodes at a lateral distance (d) from the borehole wall which is at least equal to the longitudinal spacing (b) between the electrodes (34, 37) of said first pair in order to produce a signal representative of the resistivity of the borehole fluids, from the transmitting means and the detecting means, for various positions of the body in the borehole.

6. The apparatus according to claim 5, characterized in that said maintaining means comprise a reduced-diameter portion (22) of the body comprised between two larger-diameter portions of the body, said annular electrodes (34, 35, 36, 37) being placed on said reduced-diameter portion (22) of the body.

7. The apparatus according to claim 6, characterized by comprising inclined conical surfaces (23, 24) for connecting the reduced-diameter portion of the body to the larger-diameter portions of the body to improve the flow of borehole fluids along the body.

8. The apparatus according to claim 7, characterized in that said inclined conical surfaces (23, 24) are connected to the reduced-diameter portion of the body and to the larger-diameter portions of the body by rounded surfaces (25).

9. The apparatus according to any one of claims 5 to 8, characterized by further comprising a third pair of electrodes (38, 39) positioned on the lateral surface of the body on each side of said first electrodes (34, 37) ; the electrodes of said third -pair being electrically connected to reduce the lateral depth of investigation of the measurement.

10. The apparatus according to any one of claims 5 to 9, characterized in that the longitudinal spacing between said first electrodes (34, 37) is smaller that 2 cm.

11. The apparatus according to any one of claims 5 to 10, characterized in that said transmitting means comprise power supply means (44, 43) for passing an alternating current having a substantially constant intensity through the borehole fluids.

12. The apparatus according to any one of claims 5 to 11, characterized by further comprising : means (R1) for detecting the intensity of the electrical current passed through the borehole fluids and means responsive to the ratio of the potential difference and the intensity of the current for generating a signal representative of the resistivity of the borehole fluids.

13. The apparatus according to any one of claims 5 to 12, characterized by further comprising a temperature sensor (27) fixed on said body (20) and responsive to the temperature of the borehole fluids and means (41, 42) connected to said sensor for producing a signal indicative of this temperature.

**Ansprüche**

1. Verfahren zur Messung des spezifischen Widerstandes von Fluiden in einem Bohrloch mittels eines Sonde n körpers (20), der in dem Bohrloch verlagerbar ist und auf seiner Seitenfläche ein erstes Paar von Ringelektroden (34, 37) beidseits eines zweiten Paares von Ringelektroden (35, 36) trägt, bei welchem Verfahren um den Sondenkörper ein elektrischer Strom (i) in die Bohrlochfluide zwischen den Elektroden eines der Paare emittiert wird und man eine Potentialdifferenz (u) in den Bohrlochfluiden zwischen den Elektroden des anderen Paares erfaßt, dadurch gekennzeichnet, daß man die Elektroden (34, 35, 36, 37) auf einem seitlichen Abstand (d) von der Bohrlochwandung hält, der mindestens gleich dem Längsabstand (b) zwischen den Elektroden (34, 37) des ersten Paares ist, um ein Signal für den spezifischen Widerstand der Fluide des Bohrlochs abzuleiten unabhängig von der Position des Körpers im Bohrloch.

2. Verfahren nach Anspruch 1, dadurch gekennzeichnet, daß man ein drittes Ringelektrodenpaar (38, 39), das auf der Seitenfläche des Körpers beidseits des ersten Elektrodenpaares (34, 37) angeordnet ist, auf im wesentlichen demselben elektrischen Potential verbindet zum Verringern der Tiefe der seitlichen Untersuchung der Messung.

3. Verfahren nach Anspruch 1, dadurch gekennzeichnet, daß es den Schritt des Minimierens der schnellen Veränderungen des Körperdurchmessers (20) umfaßt zum Erleichtern der Strömung der Bohrlochfluide längs des Körpers.

4. Verfahren nach einem der Ansprüche 1 bis 3, dadurch gekennzeichnet, daß es darüberhinaus die folgenden Schritte umfaßt : Erfassen der Temperatur der Bohrlochfluide mittels eines Meßaufnehmers (27), der auf der Seitenfläche des Körpers (20) angeordnet ist zum Gewinnen eines für diese Temperatur repräsentativen Signals, und Kombinieren der für die Temperatur und den spezifischen Widerstand repräsentativen Signale zum Gewinnen eines korrigierten Signals des spezifischen Widerstandes der Bohrlochfluide.

5. Gerät zur Durchführung des Verfahrens nach Anspruch 1 mit einem in dem Bohrloch verlagerbaren Körper, der auf seiner Seitenfläche ein erstes Paar von Ringelektroden (34, 37) beidseits eines zweiten Paare von Ringelektroden (35, 36) aufweist, mit

— Emittiereinrichtungen (42, 43, 44) zum Emittieren des elektrischen Stromes (i) um den gesamten Umfang des Körpers in die Bohrlochfluide zwischen den Elektroden des genannten Paares, und mit

— Erfassungseinrichtungen (46, 49, 51, 52, 53) zum Erfassen einer Potentialdifferenz (u) in den Bohrlochfluiden zwischen den Elektroden des anderen Paares, dadurch gekennzeichnet, daß das Gerät Einrichtungen (22, 23, 24) auf dem Körper aufweist zum Halten der Elektroden auf einem seitlichen Abstand (d) von der Bohrlochwandung, der mindestens gleich dem Längsabstand (b) zwischen den Elektroden (34, 37) des ersten Paares ist, um mittels der Emissions- und Erfassungseinrichtungen ein Signal zu erhalten, das repräsentativ ist für den spezifischen Widerstand der Bohrlochfluide unabhängig von der Position des Körpers im Bohrloch.

6. Gerät nach Anspruch 5, dadurch gekennzeichnet, daß die Einrichtung zum Halten der Elektroden auf einem seitlichen Abstand von der Bohrlochwandung einen Abschnitt des Sondenkörpers (22) mit verringertem Durchmesser umfaßt, der zwischen zwei Sondenkörperabschnitten mit größerem Durchmesser liegt, wobei die Ringelektroden (34, 35, 36, 37) auf dem genannten Körperabschnitt (22) mit verringertem Durchmesser angeordnet sind.

7. Gerät nach Anspruch 6, dadurch gekennzeichnet, daß das Gerät konisch abgeschrägte Oberflächen (23, 24) aufweist zum Verbinden des Körperabschnitts mit verringertem Durchmesser (22) mit den Abschnitten größeren Durchmessers zum Erleichtern der Strömung der Bohrlochfluide längs des Körpers.

8. Gerät nach Anspruch 7, dadurch gekennzeichnet, daß die konischen Schrägflächen (23, 24) mit dem Abschnitt des Körpers verringerten Durchmessers und den Abschnitten des Körpers größeren Durchmessers durch abgerundete Flächen (25) verbunden sind.

9. Gerät nach einem der Ansprüche 5 bis 8, dadurch gekennzeichnet, daß das Gerät ein drittes Elektrodenpaar (38, 39) umfaßt, das auf der Seitenfläche des Körpers beidseits der ersten Elektroden (34, 37) angeordnet ist und miteinander verbunden ist zum Verringern der Tiefe der seitlichen Untersuchung der Messung.

10. Gerät nach einem der Ansprüche 5 bis 9, dadurch gekennzeichnet, daß der Längsabstand zwischen den ersten Elektroden (34, 37) kleiner als 2 cm ist.

11. Gerät nach einem der Ansprüche 5 bis 10, dadurch gekennzeichnet, daß die Emittiereinrichtungen Speiseeinrichtungen (44, 43) umfassen zum Emittieren eines Wechselstromes im wesentlichen konstanter Intensität in die Bohrlochfluide.

12. Gerät nach einem der Ansprüche 5 bis 11, dadurch gekennzeichnet, daß das Gerät zusätzlich Mittel (R1) umfaßt zum Erfassen der Intensität des in die Bohrlochfluide emittierten Stromes sowie Mittel, die empfindlich für das Verhältnis der Potentialdifferenz und der Stromintensität sind zum Gewinnen eines Signals, das repräsentativ ist für den spezifischen Widerstand der Bohrlochfluide.

13. Gerät nach einem der Ansprüche 5 bis 12, dadurch gekennzeichnet, daß es zusätzlich einen auf dem Körper (20) angeordneten Meßaufnehmer (27) umfaßt, der empfindlich für die Temperatur der Bohrlochfluide ist, sowie Mittel (41, 42), die mit dem Meßaufnehmer verbunden sind zum Gewinnen eines Signals, das repräsentativ ist für diese Temperatur.

FIG. 1

FIG. 2

1

FIG. 3

FIG. 4

FIG. 5

FIG. 6